(19) Europäisches Patentamt
European Patent Office
Office européen des brevets

(11) **EP 0 446 002 B1**

(12) **EUROPEAN PATENT SPECIFICATION**

(45) Date of publication and mention
of the grant of the patent:
**06.08.1997 Bulletin 1997/32**

(51) Int Cl.⁶: **G06F 11/00**, G06F 11/20,
G11C 8/00

(21) Application number: **91301781.0**

(22) Date of filing: **04.03.1991**

(54) **Wafer scale memory having improved multi-bit accessing and system having the wafer scale memory**

Auf einem Wafer integrierter Speicher mit Multibitzugang und System mit demselben Speicher

Mémoire à l'échelle d'une tranche à accès multibit et système de mémoire à l'échelle d'une tranche

(84) Designated Contracting States:
**DE GB**

(30) Priority: **05.03.1990 JP 53160/90**
**12.03.1990 JP 60546/90**

(43) Date of publication of application:
**11.09.1991 Bulletin 1991/37**

(73) Proprietor: **FUJITSU LIMITED**
**Kawasaki-shi, Kanagawa 211 (JP)**

(72) Inventor: **Ikehara, Shohei**
**Yokohama-shi, Kanagawa, 244 (JP)**

(74) Representative: **Billington, Lawrence Emlyn et al**
**Haseltine Lake & Co.,**
**Imperial House,**
**15-19 Kingsway**
**London WC2B 6UD (GB)**

(56) References cited:
US-A- 3 803 562        US-A- 3 882 470
US-A- 4 007 452        US-A- 4 089 063
US-A- 4 188 670

• IBM TECHNICAL DISCLOSURE BULLETIN vol.
13, no. 7, December 1970, ARMONK, USA pages
1927 - 1928 N. F. BRICKMAN

## Description

BACKGROUND OF THE INVENTION

The present invention generally relates to wafer scale memories, and more particularly to improvements in multi-bit accessing to a wafer scale memory. Further, the present invention is concerned with a system having such a wafer scale memory.

A wafer scale memory has a plurality of chips on a single wafer and has an extremely large storage capacity. The chips on the wafer are mutually connected via a network. Generally, some of the chips are defective due to problems of the production process. Thus, it is necessary to mutually connect normal chips and avoid the use of the defective chips. In this case, it is necessary to effectively use the normal chips other than the defective chips. Recently, various methods for using the normal chips have been proposed.

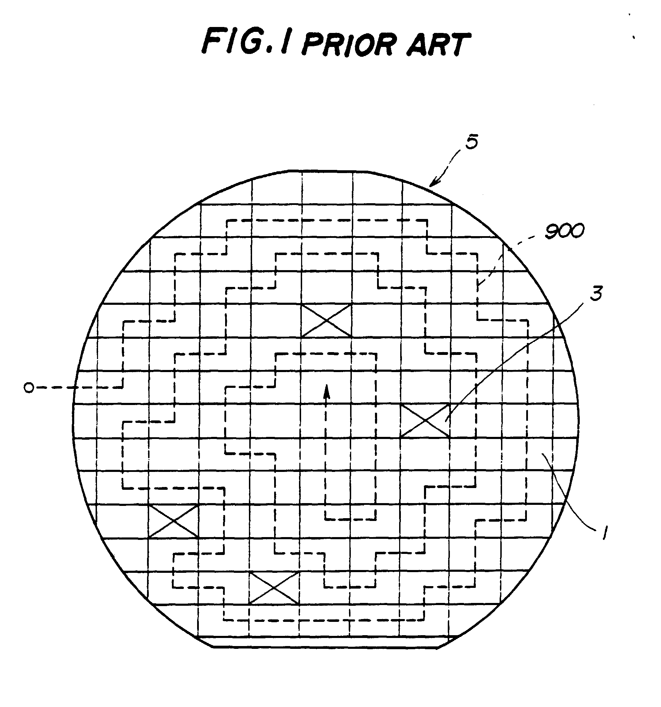

FIG.1 illustrates an outline of a conventional wafer scale memory. A spiral network 900 depicted by the broken line mutually connects just normal memory chips 1 of a wafer scale memory 5 other than defective memory chips 3 indicated by cross marks. Each of the memory chips 1 has a network circuit which connects the network 900 connected to its input to any of the adjacent memory chips so that the defective memory chips are prevented from being connected to the spiral network 900.

When the wafer scale memory 5 is accessed by a plurality of bits (multiple bits), the spiral network 900 has bit lines equal in number to the multiple bits. Alternatively, when the memory chips have four-bit or eight-bit memory structures, the spiral network 900 having a single bit line is used. However, in the case where the spiral network 900 has a plurality of bit lines, it is very difficult to bypass the defective memory chips 3, particularly, due to the locations thereof and thus efficiently use only the normal memory chips 1. In the case where the memory chips 1 having the four-bit or eight-bit structures are used, the network circuits provided therein have a large size, and further there is an increased possibility that the network circuits are defective. Furthermore, since the spiral network 900 is long, memory chips connected to an end portion of the spiral network 900 receive signals at times different from those when memory chips connected to a beginning portion thereof receive the signals. That is, all the memory chips 1 do not receive the same signal at the same time.

An alternative method of organising memories on a wafer in a spiral format is disclosed in US-A-4,007,452.

SUMMARY OF THE INVENTION

It is a general object of the present invention to provide an improved wafer scale memory in which the above-mentioned disadvantages are eliminated.

A more specific object of the present invention is to provide a wafer scale memory in which normal memory chips are efficiently used and receive a signal at almost the same time.

According to the invention, as defined in the appended claims, there is thus provided a wafer scale memory device comprising: a wafer scale memory; and a memory access control circuit, said wafer scale memory comprising: a wafer; a plurality of memory chips arranged into rows and columns; address lines provided for the respective columns; N data lines provided for the respective columns where N is an arbitrary integer; and common signal lines provided for the respective columns, each of said memory chips comprising: a data storage circuit having a plurality of memory cells, data being written into or read out from said data storage circuit via a corresponding one of said N data lines, and said memory cells being specified by an in-chip address signal transferred via a corresponding one of said common signal lines; storage means for storing the chip address of the respective memory chip in which said register means is provided; and comparing means for comparing said chip address stored in said storage means with a chip address transferred via a corresponding one of said address lines and for generating an instruction signal showing that said corresponding one of said memory chips is selected when said chip address stored in said storage means is the same as said chip address transferred via said corresponding one of said address lines, characterised in that said storage means is a first register means, and in that said memory access control circuit comprises M input/output data lines connected to an external device, M being smaller than N; selector means for selecting M data lines from said N data lines in accordance with a select signal; and address generating means for generating said select signal and chip addresses to be transferred via the M address lines from an external address signal.

BRIEP DESCRIPTION OF THE DRAWINGS

For a better understanding of the invention and to show how the same may be carried into effect, reference will now be made, purely by way of example, to the accompanying drawings, in which:-

FIG.1 is a diagram illustrating a conventional wafer scale memory;

FIG.2 is a block diagram of a system having a wafer scale memory according to a first preferred embodiment of the present invention;

FIG.3 is a block diagram of each memory chip on the wafer scale memory shown in FIG.2;

FIG.4A is a diagram illustrating data stored in an address data storage circuit shown in FIG.2;

FIG.4B is a diagram illustrating an example of data stored in the address data storage circuit;

FIG.5A is a circuit diagram of a part of an address output circuit shown in FIG.2;

FIG.5B is a block diagram of another part of the address output circuit;

FIG.5C is a circuit diagram of yet another part of the address output circuit;

FIGS.6A and 6B are diagrams illustrating how to use the wafer scale memory shown in FIG.2;

FIG.7 is a block diagram illustrating the principle of a second preferred embodiment of the present invention;

FIG.8 is a diagram illustrating data stored in the address data storage circuit used in the second embodiment of the present invention;

FIG.9 is a circuit diagram illustrating the configuration of the address output circuit used in the second embodiment of the present invention;

FIG.10 is a diagram illustrating an allocation of chip addresses;

FIG.11 is a block diagram of a system having a wafer scale memory according to a third preferred embodiment of the present invention;

FIG.12 is a block diagram of each memory chip shown in FIG.11;

FIG.13A is a diagram illustrating data stored in the address data storage circuit used in the third embodiment of the present invention shown in FIG.11;

FIG.13B is a diagram illustrating an example of data stored in the address data storage circuit shown in FIG.11;

FIGS.14 and 15 are diagrams illustrating the operation of the third preferred embodiment of the present invention; and

FIG.16 is a block diagram of a wafer scale memory in which a memory access control circuit is formed on a wafer.

## DESCRIPTION OF THE PREFERRED EMBODIMENTS

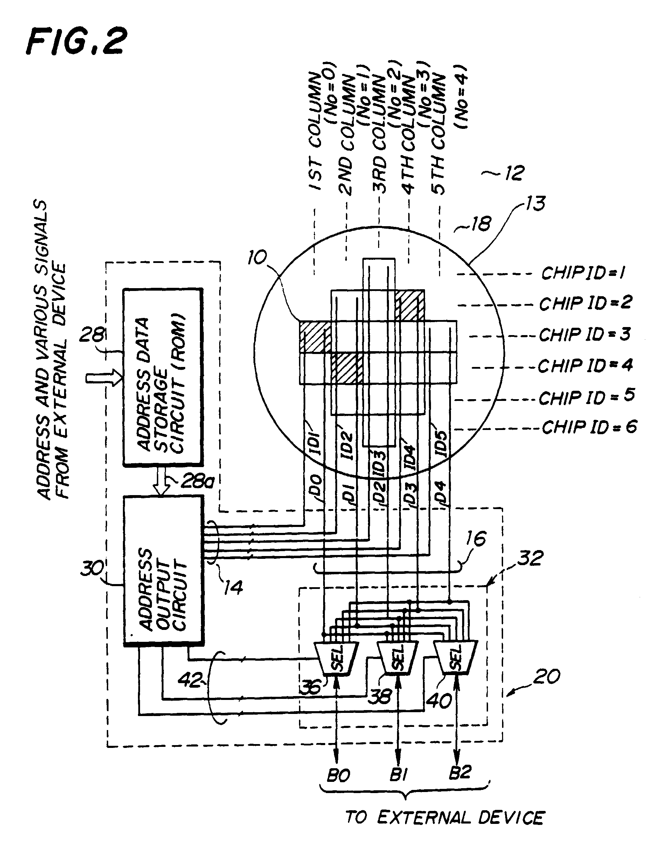

A description will now be given of a first embodiment of the present invention with reference to FIG.2. A wafer scale memory 18 has a plurality of memory chips 10 (18 memory chips are shown in FIG.2), which are arranged in a plurality of rows (six rows) and a plurality of columns 12 (five columns) on a wafer 13. A plurality of memory chips 10 (three memory chips as illustrated by hatched blocks, for example) can be accessed at the same time by a multi-bit accessing procedure. A group of address lines 14 and a group of data lines 16 are arranged so that the address lines 14 (more specifically labeled ID1 - ID5) are provided for the respective columns 12 and the data lines 16 (more specifically labeled D0 - D4) are provided for the respective columns 12. Each of the memory chips 10 is connected to the corresponding address line and data line 16.

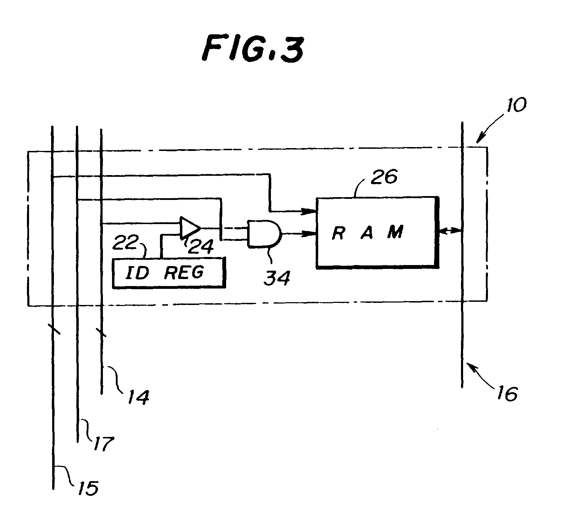

Each of the memory chips 10 has a configuration shown in FIG.3. Each memory chip 10 has a chip address register 22, an address comparator 24, a data storage device (RAM) 26 and an AND gate 34. The chip address register 22 stores a chip address (chip identical number) which identifies the memory chip in which the above chip address register 22 is provided. The wafer scale memory 18 has five chip addresses ID (ID = 1, 2, 3, 4 and 5) and the chip address register 22 of each of the memory chips 10 has the corresponding chip address. The address comparator 24 compares the chip address with a chip address transferred via the corresponding address line 14, and outputs the comparison result to the AND gate 34. The chip address transferred via the address line 14 is generated by an address output circuit 30 of a memory access control circuit 20, as will be described in detail later. A chip select signal transferred via a chip select line 17 is applied to the AND gate 34. The chip select signal is a row address strobe ($\overline{RAS}$) signal, for example. When the signal transferred via the chip select line 17 is the same as the output signal from the address comparator 24 (for example, when both the signals are high), the AND gate 34 passes the chip select signal, which is then applied to an input side of the RAM 26, so that the RAM 26 is made active. An output side of the RAM 26 is connected to the corresponding data line 16. Data is written into and read out from the RAM 26 via the data line 16. A common signal line 15, composed of a plurality of one-bit lines, carries address bits which designate a cell in the RAM 26, and various timing signals, such as write enable signals $\overline{WE}$ and a column address strobe ($\overline{CAS}$) signal.

The wafer scale memory 18 is controlled by the memory access control circuit 20, which has an address data storage circuit 28 formed of, for example, a ROM and a data line select circuit 32 in addition to the above-mentioned address output circuit 30. Address data generated and output by an external device (not shown) is input to the address data storage circuit 28. The address data has information which chips should be selected and information which cell in each of the selected chips should be accessed. Timing signals are also input to the address data storage circuit 28.

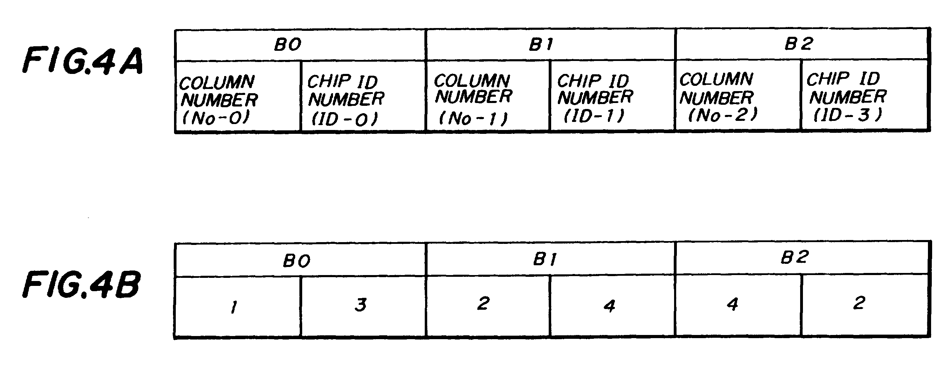

As shown in FIG.4A, the address data storage circuit 28 stores, for the three respective output data bits (input/output data lines) B0, B1, B2 obtained from the memory access control circuit 20, data (column number: No-0, No-1, No-2) indicating which one of the columns should be selected and data (chip ID-0, ID-1 and ID-2) indicating which one of the memory chips should be selected. The three hatched memory chips 10 shown in FIG.2 are designated, as shown in FIG.4B. For example, the column number (column No-0) and the chip identification number (chip ID-0) with respect to input/output data bit B0 are 1 and 3, respectively. That is, the memory chip 10 located at (3 (row), 1 (column)) is associated with input/output data bit B0. Similarly, the memory chip 10 located at (4, 2) is associated with input/output data bit B1, and the memory chip 10 located at (2, 4) is associated with input/output data bit B2.

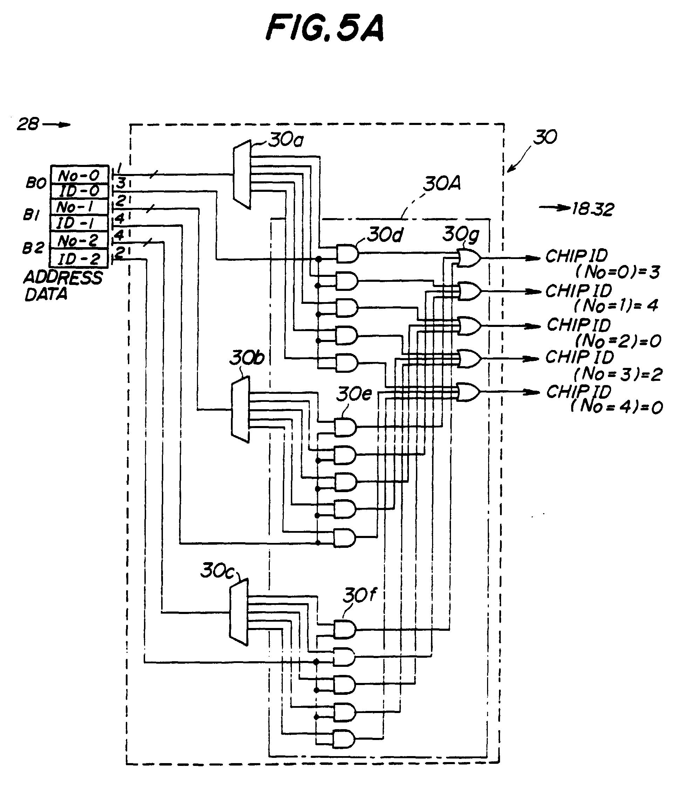

FIG.5A illustrates a part of the address output circuit 30 shown in FIG.2. The address output circuit 30 receives the column number No-0 and the chip identification number ID-0 with respect to the input/output data bit B0, the column number No-1 and the chip identification number ID-1 with respect to the input/output data bit B1, and the column number No-2 and the chip identification number ID-2 with respect to the input/output data bit B2. It will be noted that the column numbers supplied to the address output circuit 30 are specifically represented by No-0, No-1 and NO-2 and that the chip identification numbers (chip ID) supplied thereto are specifically represented by ID-0, ID-1 and ID-2.

The address output circuit 30 has decoders 30a, 30b and 30c, and a logical circuit 30A. The decoder 30a decodes the column number No-0 described by a plurality of bits and generates decoded signals. For example, the decoder 30a receives 1 (column number No = 1) and sets the corresponding signals among the decoded signals to a high level. Similarly, the decoders 30b and 30c decode the column numbers No-1 and No-2 and generate decoded signals, respectively. The decoded signals generated by the decoders 30a, 30b and 30c are input to the logic circuit 30A.

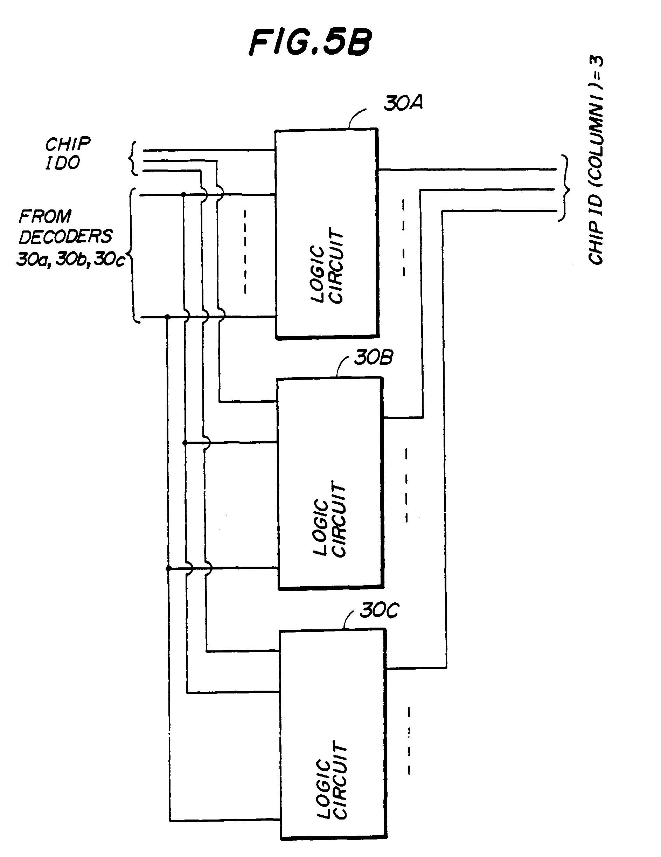

The chip identification number (chip address ID) is described by a plurality of bits. That is, the chip identification number ID-i (i = 0, 1, 2) supplied to the address output circuit 30 is described by a plurality of bits. For example, the chip identification number ID-i is input to the address output circuit 30 via a plurality of bit lines in parallel form. It will be noted that one of such bit lines is shown in FIG.5A. As shown in FIG.5B, logic circuits 30A, 30B and 30C, which are the same as each other, are provided for the respective bit lines (three bits in the case shown in FIG.5B) which carry the chip identification number.

Turning now to FIG.5A, the logic circuit 30A is composed of a group of AND gates 30d, a group of AND gates 30e, a group of AND gates 30f, and a group of OR gates 30g. The group 30d receives one of the bits of the chip identification number ID-0 for the input/output data bit B0, and the decoded signals from the decoder 30a. The group 30e receives one of the bits of the chip identification number ID-1 for the input/output data bit B1, and the decoded signals from the decoder 30b. The group 30f receives one of the bits of the chip identification number ID-2, and the decoded signals from the decoder 30c. Each of the OR gates 30g receives output signals of the corresponding AND gates of the groups 30d, 30e and 30f, and one of the three bits forming the corresponding chip identification number is supplied to the corresponding column. In this way, each of the logic circuits 30A, 30B and 30C outputs one of the three bits of the chip identification number for each of the columns. For example, the chip ID for the first column (No = 0) is 3. Similarly, the chip identification numbers for the second through fifth columns are obtained as shown in FIG. 5A. It is noted that a chip identification number of zero means that the corresponding column has no memory chip to be selected. In the case shown in FIG.2, the chip identification numbers of the third column (No = 2) and the fifth column (No = 4) are zero, as shown in FIG.5A.

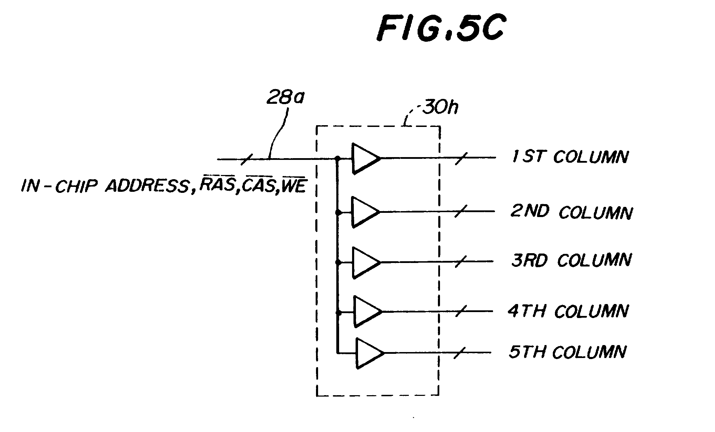

As shown in FIG.5C, the address output circuit 30 also has a group of buffers 30h provided for the respective columns. The buffer group 30h receives in-chip address information for specifying a memory cell of the RAM, the $\overline{RAS}$ signal, the $\overline{CAS}$ signal and the $\overline{WE}$ signal via a bus 28a from the address data storage circuit (RAM) 26. These signals pass through the buffers 30h and are supplied to the respective columns.

Turning now to FIG.2, the data line select circuit 32 has three selectors 36, 38 and 40, which are controlled by the address output circuit 30 via control lines 42. The decoded signals of the decoders 30a, 30b and 30c (FIG. 5A) are supplied to the selectors 36, 38 and 40, respectively. Alternatively, it is possible to directly supply the selectors 36, 38 and 40 with the column numbers supplied from the address data storage circuit 28. Each of the selectors 36, 38 and 40 is connected to the five data lines 16, and selects one of the data lines specified by the corresponding one of the decoders 30a, 30b and 30c. The data lines 16 selected by the selectors 36, 38 and 40 are respectively connected to the input/output data lines B0, B1 and B2, which are coupled to the external device.

The chip identification numbers shown in FIG.5A obtained in the aforementioned procedure are output to the address lines 14 (ID1, ID2, ID3, ID4, ID5). More specifically, chip identification numbers 3, 4, 0, 2 and 0 are output to the address lines ID1, ID2, ID3, ID4 and ID5, respectively. The address comparator 24 of each memory chip 10 shown in FIG.3 compares the chip identification number (chip address) with the chip identification number transferred via the address line 14. When both the signals are the same as each other and the chip select signal (RAS signal, for example) is supplied via the chip select line 17, the AND gate 34 passes the chip select signal, so that the RAM 26 is made active. During the operation of the RAM 26, various timing and control signals necessary for the operation thereof are supplied thereto via the common signal line 15 extending from the address output circuit 30.

In the above-mentioned way, arbitrary three memory chips can be accessed at one time. It should be noted that the address lines 14 and the data lines 16 are provided for the respective columns of the arrangement of the memory chips 10, the aforementioned problems of the conventional structure can be eliminated.

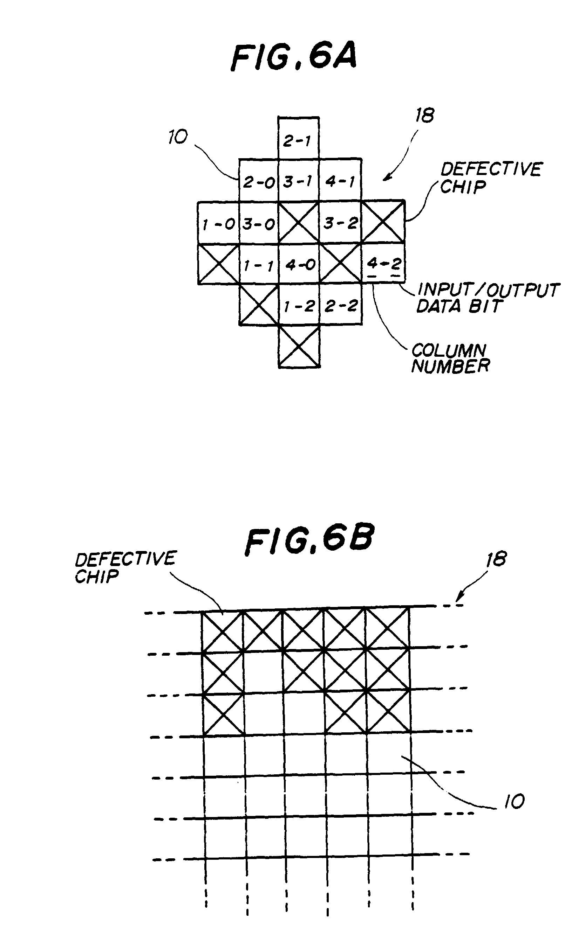

As shown in FIG.6A, it is possible to select only the normal memory chips 10 to avoid the defective memory chips. Further, as shown in FIG.6B, it is possible to logically distinguish the normal memory chips 10 from the defective memory chips and to attain a simple memory accessing procedure, as compared with the conventional memory accessing procedure.

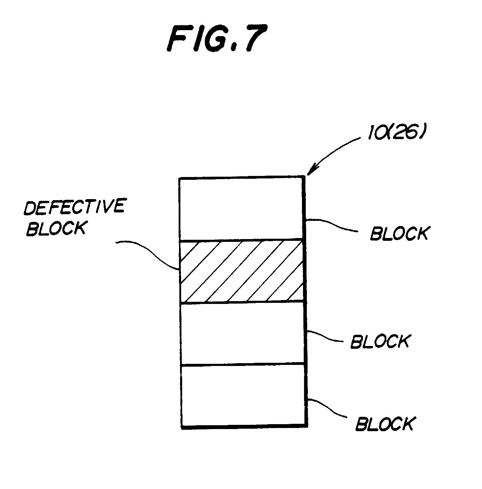

A description will now be given of a second preferred embodiment of the present invention. As shown in FIG.7, the storage area of the RAM 26 (FIG.3) of each memory chip 10 is divided into a plurality of blocks (four blocks in FIG.7). The first embodiment of the present invention can access a plurality of memory chips at one time, while the second embodiment of the present invention can further specify one of the four blocks of each of the accessed memory chips. According to the first embodiment of the present invention, each defective memory chip is not permitted to be used even if it is partially damaged. On the other hand, according to the second embodiment of the present invention, even if the hatched block shown in FIG.7 is defective, the other three blocks can be used by a block accessing procedure, which will be described below.

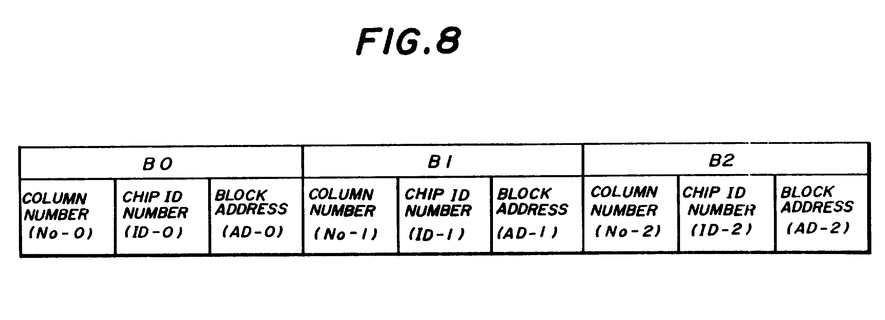

In order to realize the block accessing procedure, as shown in FIG.8, the address data storage circuit 28 shown in FIG.2 stores, for each of the input/output data bits (B0, B1 and B2), a block address (AD-0, AD-1, AD-2) in addition to the aforementioned column number (No-0, No-1, No-2), and the chip identification number (ID-0, ID-2, ID-3). The block address consists of two bits, when the entire storage area of the RAM 26 is divided into four blocks.

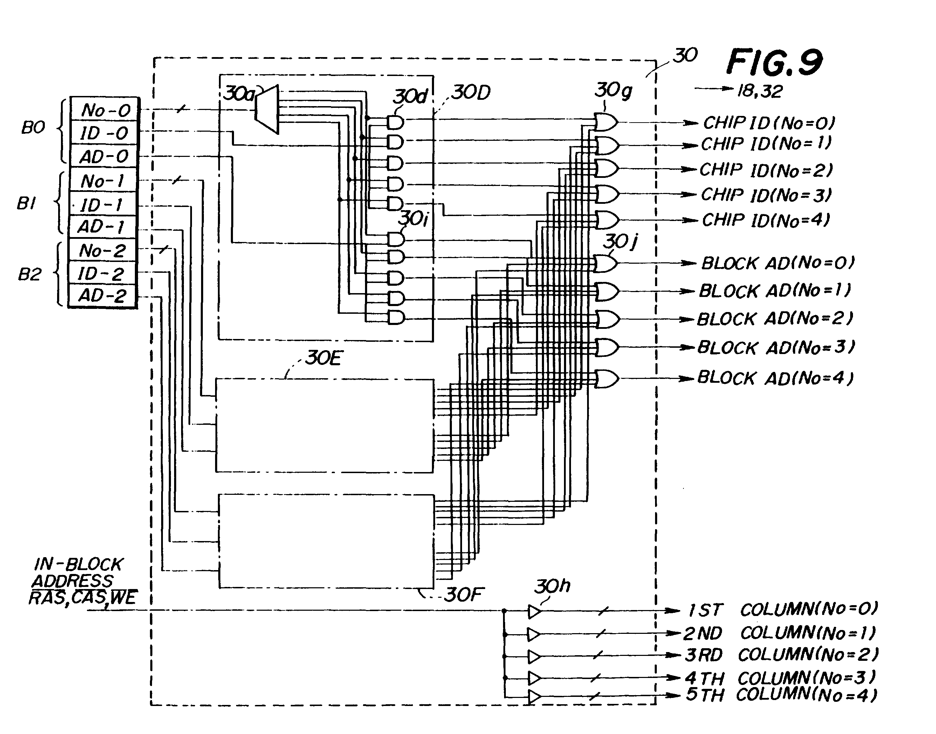

FIG.9 is a block diagram illustrating the structure of the address output circuit 30 used in the second embodiment of the present invention. In FIG.9, those parts which are the same as those shown in FIG.5A is given the same reference numerals. The address output circuit 30 shown in FIG.9 has three logical blocks 30D, 30E and 30F provided for the respective input/output data bits B0, B1 and B2. The logical block 30D provided for the input/output data bit B0 comprises a group of AND gates 30i in addition to the aforementioned decoder 30a and the group of AND gates 30d. The AND gates 30i receive one of the block address consisting of a plurality of bits (two bits, for example). The AND gate group 30i is provided for each of the bits of the block address. For the sake of simplicity, only one group 30i is illustrated in FIG.9. Output signals of the AND gates 30i are supplied to a group of OR gates 30j. Similarly, output signals of groups of AND gates 30i (not shown) provided in the logical blocks 30E and 30F are supplied to the group of OR gates 30j. The group of OR gates 30i illustrated shown in FIG.9 outputs one-bits of the block addresses supplied to the respective columns. The in-chip address from the address output circuit 30 is applied to the respective columns as in-block address.

The block addresses generated in the above-mentioned way are supplied to the RAMs 26 via the common signal lines 15 shown in FIG.3. That is, each of the common signal lines 15 includes the corresponding line extending from the buffer group 30h and the corresponding line extending from the OR gate group 30j.

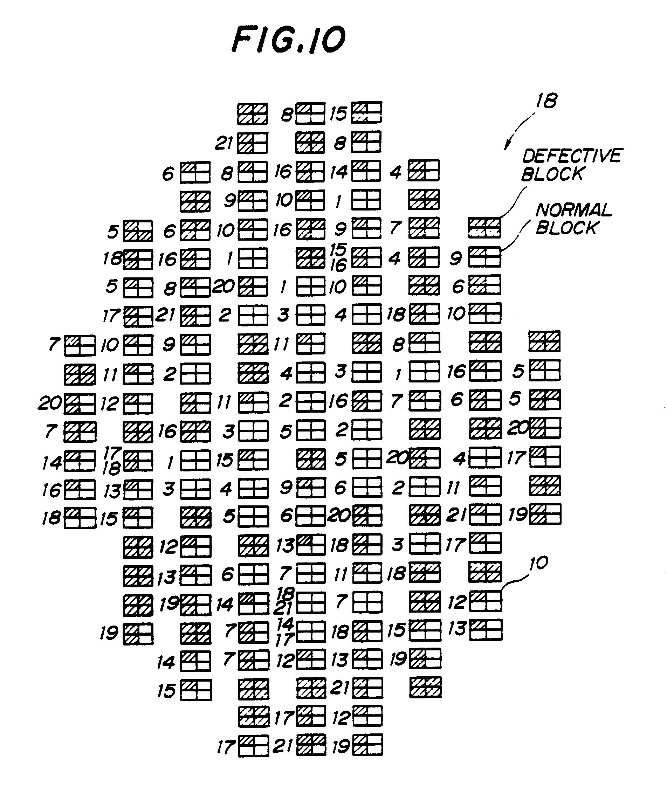

FIG.10 shows blocks of the memory chips 10. Numerals attached to the memory chips 10 indicate allocation of the chip address (chip identification number). According to the second embodiment of the present invention, it is possible to use only the normal blocks other than the defective blocks, so that the entire storage capacity of the wafer scale memory 18 can be utilized efficiently and effectively.

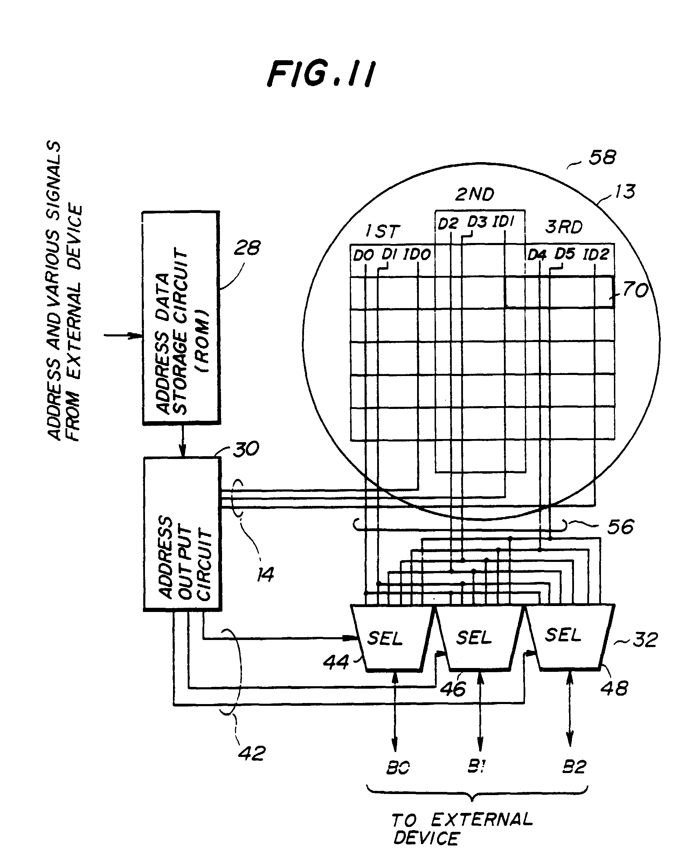

A description will now be described of a third preferred embodiment of the present invention with reference to FIG.11, in which those parts which are the same as those shown in the previous figures are given the same reference numerals. A wafer scale memory 58 comprises memory chips 70 arranged into rows (eight rows) and columns (three columns). Data lines 56 are provided for the columns so that a pair of data lines is provided for each of the columns. More specifically, data lines D0 and D1 are provided for the first column (column No = 0), data lines D2 and D3 are provided for the second column (column No = 1), and data lines D4 and D5 are provided for the third column (column No = 2). The data select circuit 32 has three selectors 44, 46 and 48. Each of the selectors 44, 46 and 48 selects one of the data lines D0 - D5 under the control of the address output circuit 30 and connects the selected data line to the corresponding input/output data line B0, B1, B2.

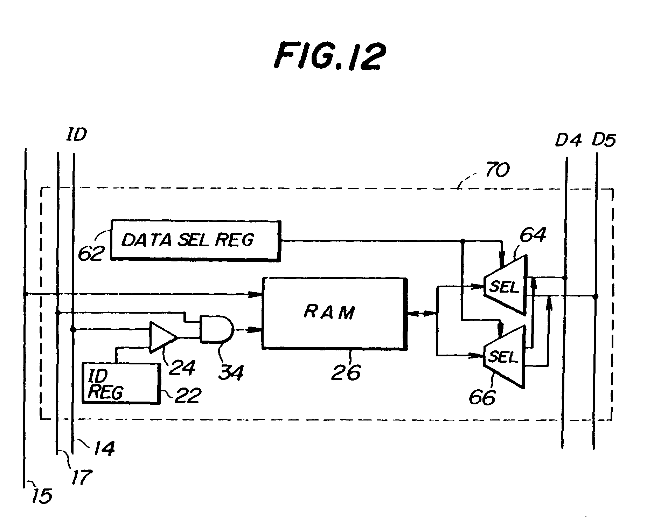

FIG.12 shows a configuration of the memory chip 70 positioned in the third column shown in FIG.11. The configuration of each of the other memory chips 70 is the same as that shown in FIG.12. In this figure, those parts which are the same as those shown in the FIG.3 are given the same reference numerals. The memory chip 70 has a data select register 62, and two selectors 64 and 66 in addition to the configuration shown in FIG. 3. The data select register 62 stores information indicating which one of the data lines D4 and D5 should be selected. The information in the data select register 62 is supplied to the selectors 64 and 66, so that the RAM 26 is connected to either the data line D4 or the data line D5. As will be described later, the chip address register 22 stores the order of accessing.

The address output circuit 30 stores, for each of the input/output data lines B0, B1 and B2, a data number (DNo-1, DNo-2, DNo-3) and a chip identification number (ID-0, ID-1, ID-2). The data number shows which one of the two data lines (D0, D1; D2, D3; D4 and D5) should be selected and connected to the RAM 26.

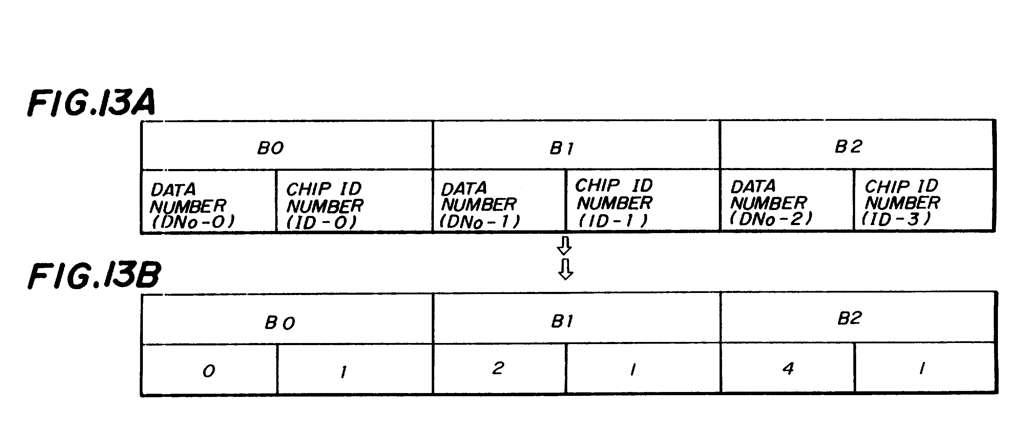

FIG.13B shows an example of the data stored in the address data storage circuit 28. In FIG.13B, the memory chip 70 connected to the data line D0 (DNo-0 = 0) in the first column (No = 0) and having "1" stored in the chip address register 22 is accessed. Similarly, the memory chip 70 connected to the data line D2 (DNo-1 = 2) in the second column (No = 1) and having "1" stored in the chip address register 22 is accessed. Similarly, the memory chip 70 connected to the data line D4 (DN0-2 = 4) in the third column (No = 2) and having "1" stored in the chip address register 22 is accessed.

The chip identification numbers ID-0, ID-1 and ID-2 are output to the address lines ID0, ID1 and ID2 from the address output circuit 30. Further, the address output circuit 30 supplies each of the selectors 44, 46 and 48 with information showing which one of the data lines D0 - D5 should be selected.

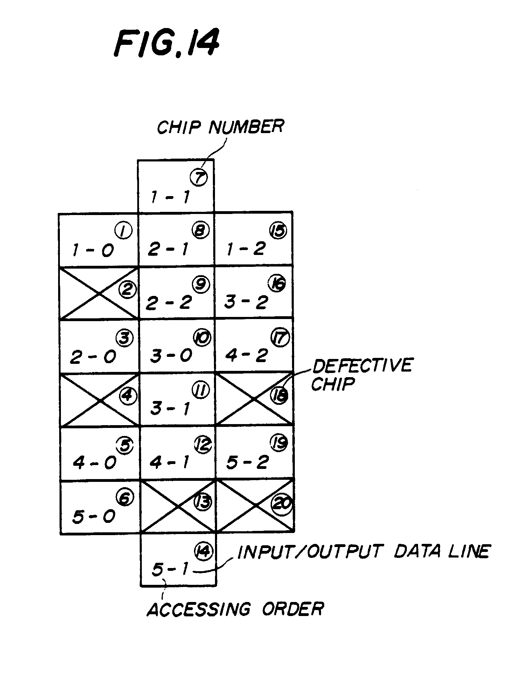

A description will now be given of the operation of the system shown in FIG.11. FIG.14 shows the arrangement of the memory chips 70 shown in FIG.11. In FIG. 14, each numeral surrounded by a circle is information identifying each memory chip (chip number). Blocks having crosses denote defective memory chips. In FIG. 14, memory chips ②, ④ ⑬, ⑱ and ⑳ are defective. Further, two numerals coupled by a hyphen, such as 1-0, are defined as follows. The numeral on the left side shows when the corresponding memory chip should be accessed. When the first chip accessing is carried out, memory chips ①, ⑦ and ⑮ are accessed. During the second chip accessing which is carried out by incrementing the chip address by +1, memory chips ③ ⑧ and ⑨ are accessed. The numeral on the right side shows which one of the input/output data lines B0, B1 and B2 should be connected to the memory chip being considered.

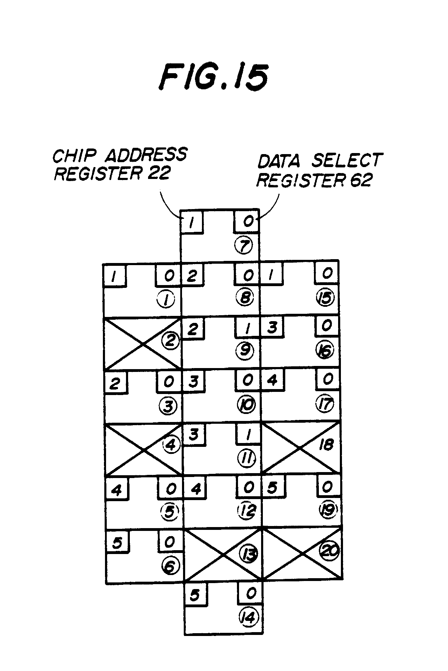

FIG.15 shows the contents of the chip address register 22 and the data select register 62 provided in each of the memory chips 70. For example, in the third chip accessing, memory chips ⑩, ⑪ and ⑯ having '3' in the chip address registers 22 thereof are accessed. When the chip identification number (chip address) equal to 3 generated and output by the address output circuit 30 is supplied to the memory chips ⑩, ⑪ and ⑯, they are made active. Since the data select registers 62 of the memory chips ⑩, ⑪ and ⑯ have '0', '1' and '0', respectively, data are written into or read out from the memory chips ⑩, ⑪ and ⑯ via the data lines D2, D3 and D4.

During the first accessing, the address output circuit 30 outputs chip identification number '1' to each of the address lines ID0, ID1 and ID2. Then, the memory chips ①, ⑦ and ⑮ having "1" in the chip address registers 22 thereof are selected. Since the data select registers 62 of the selected memory chips ①, ⑦ and ⑮ have '0', the memory chips ①, ⑦ and ⑮ are connected to the data lines D0, D2 and D4, respectively.

On the other hand, the address output circuit 30 outputs the data numbers '0' (= DNo-0), '2' ( = DNo-1) and '4' (DNo-2) to the selectors 44, 46 and 48 via the control lines 42. Thus, the data line D0 to which the memory chip ① is selectively connected is connected to the input/output data line B0 via the selector 44, and the data line D1 to which the memory chip ⑦ is selectively connected is connected to the input/output bit line B1 through the selector 46. Further, the data line D4 to which the memory chip ⑮ is selectively connected is connected to the input/output data line B2 through the selector 48. After that, the chip addresses to be output to the address lines ID0, ID1 and ID2 are incremented, so that they are equal to '2'. Thus, the memory chips ③ ⑧ and ⑨ are selected. Since the data select registers 62 of the memory chips ③ ⑧ and ⑨ have '0', '0' and '1', the memory chips ③ ⑧ and ⑨ are connected to the data lines D0, D2 and D3, respectively. On the other hand, the address output circuit 30 outputs the selectors 44, 46 and 48 to the data numbers '0' (= DNo-O), '2' (= DNo-1) and '3' (= DNo-2). Thus, the memory chips ③ ⑧ and ⑨ are connected to the input/output data lines B0, B1 and B2 via the data lines D0, D2 and D3, respectively.

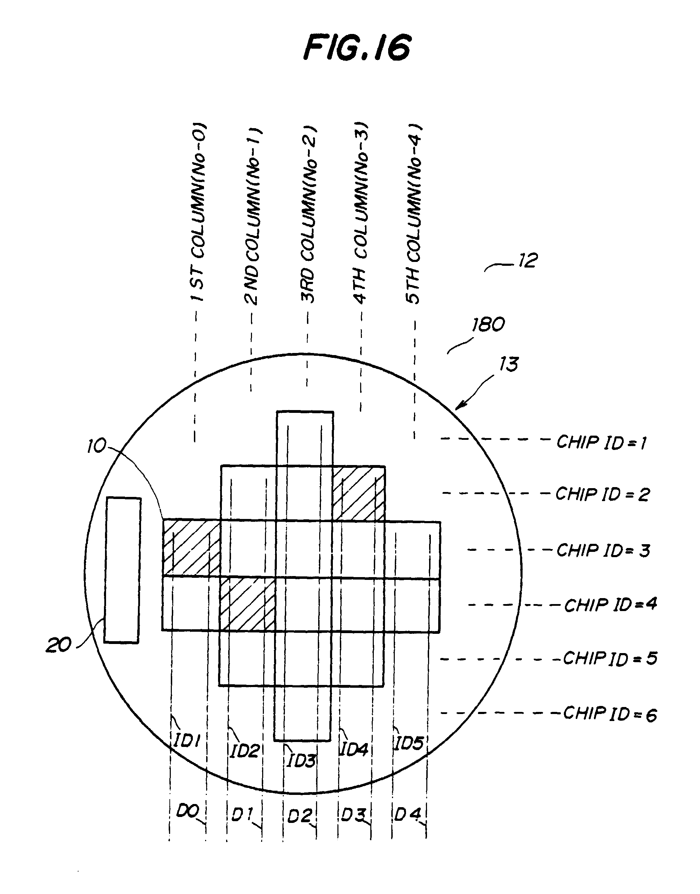

In the above-mentioned embodiments of the present invention, the memory access control circuit 20 is provided separately from the wafer scale memory 18 or 58. Alternatively, as shown in FIG.16, it is possible to form the memory access control circuit 20 on the wafer 13 of a wafer scale memory 180. It will be noted that the contents of the registers 22 and 62 can be replaced by, for example, a conventional serial access. For the sake of simplicity, lines connected to the registers 22 and 62 for the serial access are omitted. It will also be noted that each of the data lines 16 and 56 can carry data consisting of one bit or more.

The present invention is not limited to the specifically disclosed embodiments, and variations and modifications may be made without departing from the scope of the present invention as set out in the claims.

## Claims

1. A wafer scale memory device comprising:

   a wafer scale memory (18); and
   a memory access control circuit (20),

   said wafer scale memory comprising:

   a wafer (13) ;
   a plurality of memory chips (10) arranged into rows and columns;
   address lines (14) provided for the respective columns;
   N data lines (16) provided for the respective columns where N is an arbitrary integer; and
   common signal lines provided for the respective columns,

   each of said memory chips (10) comprising:

   a data storage circuit (26) having a plurality of memory cells, data being written into or read out from said data storage circuit via a corresponding one of said N data lines, and said memory cells being specified by an in-chip address signal transferred via a corresponding one of said common signal lines;
   storage means (22) for storing the chip address of the respective memory chip in which a register means is provided; and
   comparing means (24, 34) for comparing said chip address stored in said storage means with a chip address transferred via a corresponding one of said address lines and for generating an instruction signal showing that said corresponding one of said memory chips is selected when said chip address stored in said storage means is the same as said chip address transferred via said corresponding one of said address lines, characterised in that

said storage means is a first register means; and

in that said memory access control circuit (20) comprises:

M input/output data lines (B0,B1,B2) connected to an external device, M being smaller than N; selector means (32: 36, 38, 40) for selecting M data lines from said N data lines in accordance with a select signal; and

address generating means (28, 30) for generating said select signal and chip addresses to be transferred via M of the address lines from an external address signal.

2. A device as claimed in claim 1, wherein

said wafer scale memory comprises chip select lines (17) provided for the respective columns, chip select signals being transferred via the chip select lines, and

each of said memory chips comprises means (24, 34), provided between said comparing means and said data storage circuit, for receiving a corresponding one of said chip select signals and said instruction signal generated by said comparing means and for activating said data storage circuit when the corresponding one of said chip select signals and said instruction signals are received.

3. A device as claimed in claim 1 or claim 2, wherein said address generating means comprises:

memory means (28) for storing a plurality of sets of data defined for the respective M input/output data lines, each of said sets of data having, for each of said M input/output data lines, a column number specifying one of said columns and the chip address specifying one of the memory chips and for outputting one of sets of data having M column numbers and M chip addresses defined for said M input/output data lines in response to said external address signal; and

address outputting means (30) for receiving said one of the sets of data from said memory means and for outputting said M chip addresses to said M address lines in respective columns specified by said M column numbers and for outputting said M column numbers to said selector means as said select signal.

4. A device as claimed in claim 1, 2 or 3, wherein said chip address indicates a location of a corresponding one of said memory chips in a direction in which said memory chips are arranged in the rows.

5. A device as claimed in claim 1, 2, 3 or 4, wherein said chip address indicates an order of accessing a corresponding one of said memory chips in a direction in which said memory chips are arranged in the rows.

6. A device as claimed in claim 1, 2, 3, 4 or 5, wherein:

each of said memory chips has a storage area (26) having a plurality of blocks, one of said plurality of blocks being specified by a block address transferred via a corresponding one of said common signal lines, and said address generating means comprises:

memory means (28) for storing a plurality of sets of data defined for the respective M input/output data lines, each of said sets of data having, for each of said M input/output data lines, a column number specifying one of said columns, the chip address specifying one of the memory chips and a block address specifying one of said blocks and for outputting one of sets of data having M column numbers, M chip addresses and M block addresses defined for said M input/output data lines in response to said external address signal; and

address outputting means (30) for receiving said one of the sets of data from said memory means and for outputting said M chip addresses and M block addresses to the M address lines in respective columns specified by said M column numbers.

7. A device according to any preceding claim comprising:

groups of y data lines (D0, D1; D2, D3; D4, D5) being provided from said N data lines for the respective columns wherein N and Y are arbitrary integers and Y is smaller than N, data being written into or read out from said data storage circuit of one of the memory chips via one of said Y data lines, and said memory cells being specified by the in-chip address signal transferred via a corresponding one of said common signal lines;

further comprising second register means (62) for registering information indicating one of said Y data lines; and

data line selecting means (64, 66) for connecting said data storage circuit to said one of the Y data lines registered in said second register means.

8. A device as claimed in any preceding claim, wherein the number of said columns is equal to M, and wherein said address generating means (20) comprises:

memory means (28) for storing a plurality of sets of data defined for the respective M input/output data lines, each of said sets of data having, for each of said input/output data lines, a data number specifying one of said Y data lines and the chip address specifying one of the memory chips and for outputting one of sets of data having M data numbers and M chip addresses defined for said M input/output data lines in response to said external address signal; and

address outputting means (30) for receiving said one of the sets of data from said memory means and for outputting said M chip addresses and said data number to the address lines in the respective columns and outputting said M data numbers to said selector means as said select signal.

**Patentansprüche**

1. Speichervorrichtung mit Ultrahöchstintegration, die umfaßt:

einen Speicher mit Ultrahöchstintegration (18); und

eine Speicherzugriffssteuerschaltung (20), welcher Speicher mit Ultrahöchstintegration umfaßt:

einen Wafer (13);

eine Vielzahl von Speicherchips (10), die in Reihen und Spalten angeordnet sind;

Adressenleitungen (14), die für die jeweiligen Spalten vorgesehen sind;

N Datenleitungen (16), die für die jeweiligen Spalten vorgesehen sind, wobei N eine beliebige ganze Zahl ist; und

gemeinsame Signalleitungen, die für die jeweiligen Spalten vorgesehen sind,

wobei jeder der Speicherchips (10) umfaßt:

eine Datenspeicherschaltung (26), die eine Vielzahl von Speicherzellen hat, wobei Daten über eine entsprechende der N Datenleitungen in die Datenspeicherschaltung geschrieben werden oder aus ihr gelesen werden und die Speicherzellen durch ein chipinternes Adressensignal spezifiziert sind, das über eine entsprechende der gemeinsamen Signalleitungen übertragen wird; "

ein Speichermittel (22) zum Speichern der Chipadresse des jeweiligen Speicherchips, in dem ein Registermittel vorgesehen ist; und

ein Vergleichsmittel (24, 34) zum Vergleichen der Chipadresse, die in dem Speichermittel gespeichert ist, mit einer Chipadresse, die über eine entsprechende der Adressenleitungen übertragen wird, und zum Erzeugen eines Instruktionssignals, das angibt, daß der entsprechende der Speicherchips selektiert wird, wenn die Chipadresse, die in dem Speichermittel gespeichert ist, dieselbe wie die Chipadresse ist, die über die entsprechende der Adressenleitungen übertragen wurde,

dadurch gekennzeichnet, daß

das Speichermittel ein erstes Registermittel ist; und daß

die Speicherzugriffssteuerschaltung (20) umfaßt:

M Eingangs-/Ausgangsdatenleitungen (B0, B1, B2), die mit einer externen Vorrichtung verbunden sind, wobei M kleiner als N ist;

ein Selektormittel (32: 36, 38, 40) zum Selektieren von M Datenleitungen von den N Datenleitungen gemäß einem Selektionssignal; und

ein Adressenerzeugungsmittel (28, 30) zum Erzeugen des Selektionssignals und von Chipadressen, die über M der Adressenleitungen zu übertragen sind, nach einem externen Adressensignal.

2. Vorrichtung nach Anspruch 1, bei der

der Speicher mit Ultrahöchstintegration Chipselektionsleitungen (17) umfaßt, die für die jeweiligen Spalten vorgesehen sind, wobei Chipselektionssignale über die Chipselektionsleitungen übertragen werden, und

jeder der Speicherchips ein Mittel (24, 34) umfaßt, das zwischen dem Vergleichsmittel und der Datenspeicherschaltung vorgesehen ist, zum Empfangen eines entsprechenden der Chipselektionssignale und des Instruktionssignals, das durch das Vergleichsmittel erzeugt wurde, und zum Aktivieren der Datenspeicherschaltung, wenn das entsprechende der Chipselektionssignale und das Instruktionssignal empfangen sind.

3. Vorrichtung nach Anspruch 1 oder Anspruch 2, bei der das Adressenerzeugungsmittel umfaßt:

ein Speichermittel (28) zum Speichern einer Vielzahl von Datensätzen, die für die jeweiligen M Eingangs/Ausgangsdatenleitungen definiert sind, wobei jeder der Datensätze für jede der M Eingangs-/Ausgangsdatenleitungen eine Spaltennummer hat, die eine der Spalten spezifiziert, und die Chipadresse, die einen der Speicherchips spezifiziert, und zum Ausgeben eines der Datensätze, die M Spaltennummern und M Chipadressen haben, die für die M Eingangs/Ausgangsdatenleitungen definiert sind, als Reaktion auf das externe Adressensignal; und

ein Adressenausgabemittel (30) zum Empfangen des einen der Datensätze von dem Speichermittel und zum Ausgeben der M Chipadressen an die M Adressenleitungen in jeweiligen Spalten, die durch die M Spaltennummern spezifiziert sind, und zum Ausgeben der M Spaltennummern an das Selektormittel als Selektionssignal.

4. Vorrichtung nach Anspruch 1, 2 oder 3, bei der die Chipadresse eine Stelle eines entsprechenden der Speicherchips in einer Richtung bezeichnet, in der die Speicherchips in den Reihen angeordnet sind.

5. Vorrichtung nach Anspruch 1, 2, 3 oder 4, bei der die Chipadresse eine Reihenfolge des Zugreifens auf einen entsprechenden der Speicherchips in einer Richtung bezeichnet, in der die Speicherchips in den Reihen angeordnet sind.

6. Vorrichtung nach Anspruch 1, 2, 3, 4 oder 5, bei der:
jeder der Speicherchips einen Speicherbereich (26) mit einer Vielzahl von Blöcken hat, wobei einer von der Vielzahl von Blöcken durch eine Blockadresse spezifiziert ist, die über eine entsprechende der gemeinsamen Signalleitungen übertragen wird, und
das Adressenerzeugungsmittel umfaßt:

ein Speichermittel (28) zum Speichern einer Vielzahl von Datensätzen, die für die jeweiligen M Eingangs-/ Ausgangsdatenleitungen definiert sind, wobei jeder der Datensätze für jede der M Eingangs-/Ausgangsdatenleitungen eine Spaltennummer hat, die eine der Spalten spezifiziert, die Chipadresse, die einen der Speicherchips spezifiziert, und eine Blockadresse, die einen der Blöcke spezifiziert, und zum Ausgeben von einem der Datensätze, die M Spaltennummern, M Chipadressen und M Blockadressen haben, die für die M Eingangs-/Ausgangsdatenleitungen definiert sind, als Reaktion auf das externe Adressensignal; und
ein Adressenausgabemittel (30) zum Empfangen des einen der Datensätze von dem Speichermittel und zum Ausgeben der M Chipadressen und M Blockadressen an die M Adressenleitungen in jeweiligen Spalten, die durch die M Spaltennummern spezifiziert sind.

7. Vorrichtung nach irgendeinem vorhergehenden Anspruch, mit:

Gruppen von Y Datenleitungen (D0, D1; D2, D3; D4, D5), die von den N Datenleitungen für die jeweiligen Spalten vorgesehen sind, wobei N und Y beliebige ganze Zahlen sind und Y kleiner als N ist, wobei Daten über eine der Y Datenleitungen in die Datenspeicherschaltung von einem der Speicherchips geschrieben werden oder aus ihr gelesen werden und die Speicherzellen durch das chipinterne Adressensignal spezifiziert sind, das über eine entsprechende der gemeinsamen Signalleitungen übertragen wird;
ferner mit einem zweiten Registermittel (62) zum Registrieren von Informationen, die eine der Y Datenleitungen bezeichnen; und
einem Datenleitungsselektionsmittel (64, 66) zum Verbinden der Datenspeicherschaltung mit einer der Y Datenleitungen, die in dem zweiten Registermittel registriert ist.

8. Vorrichtung nach irgendeinem vorhergehenden Anspruch,
bei der die Anzahl der Spalten gleich M ist, und
bei der das Adressenerzeugungsmittel (20) umfaßt:

ein Speichermittel (28) zum Speichern einer Vielzahl von Datensätzen, die für die jeweiligen M Eingangs-/ Ausgangsdatenleitungen definiert sind, wobei jeder der Datensätze für jede der Eingangs-/Ausgangsdatenleitungen eine Datennummer hat, die eine der Y Datenleitungen spezifiziert, und die Chipadresse, die einen der Speicherchips spezifiziert, und zum Ausgeben von einem der Datensätze, die M Datennummern und M Chipadressen haben, die für die M Eingangs-/Ausgangsdatenleitungen definiert sind, als Reaktion auf das externe Adressensignal; und
ein Adressenausgabemittel (30) zum Empfangen des einen der Datensätze von dem Speichermittel und zum Ausgeben der M Chipadressen und der Datennummer an die Adressenleitungen in den jeweiligen Spalten und zum Ausgeben der M Datennummern an das Selektormittel als Selektionssignal.

**Revendications**

1. Dispositif de mémoire à l'échelle d'une tranche comprenant :

une mémoire à l'échelle d'une tranche (18) ; et

un circuit de commande d'accès mémoire (20), ladite mémoire à l'échelle d'une tranche comprenant :

une tranche (13) ;

une pluralité de puces de mémoire (10) disposées en rangées et en colonnes ;

des lignes d'adresse (14) prévues pour les colonnes respectives ;

des lignes de données (16) prévues pour les colonnes respectives où N est un entier arbitraire ; et

des lignes de signal communes prévues pour les colonnes respectives,

chacune desdites puces de mémoire (10) comprenant :

un circuit de stockage de données (26) ayant une pluralité de cellules de mémoire, les données étant écrites ou extraites dudit circuit de stockage de données via une desdites lignes de données N correspondante, et lesdites cellules de mémoire étant spécifiées par un signal d'adresse dans une puce transféré via une ligne correspondante desdites lignes de signaux communs ;

un moyen de stockage (22) pour stocker l'adresse de puce de la puce de mémoire respective dans lequel un moyen de registre est fourni ; et

un moyen de comparaison (24, 34) pour comparer ladite adresse de puce stockée dans ledit moyen de stockage à une adresse de puce transférée via une ligne correspondante desdites lignes d'adresse et pour générer un signal d'instruction montrant que ladite puce correspondante desdites puces de mémoire est sélectionnée lorsque ladite adresse de puce stockée dans ledit moyen de stockage est la même que ladite adresse de puce transférée via ladite ligne correspondante desdites lignes d'adresse, caractérisé en ce que

ledit moyen de stockage est un premier moyen de registre ; et

en ce que ledit circuit de commande d'accès de mémoire (20) comprend :

M lignes de données d'entrée/sortie (B0, B1, B2) connectées à un dispositif externe, M étant plus petit que N ;

un moyen sélecteur (32 ; 36, 38, 40) pour sélectionner M lignes de données à partir de N lignes de données selon un signal de sélection ; et

un moyen de génération d'adresse (28, 30) pour générer ledit signal de sélection et des adresses de puce à transférer via M lignes d'adresse à partir d'un signal d'adresse externe.

2. Dispositif selon la revendication 1, dans lequel ladite mémoire à l'échelle d'une tranche comprend des lignes de sélection de puce (17) prévues pour les colonnes respectives, des signaux de sélection de puce étant transférés via les lignes de sélection de puce, et

chacune desdites puces de mémoire comprend un moyen (24, 34), placé entre ledit moyen de comparaison et ledit circuit de stockage de données, pour recevoir un signal correspondant desdits signaux de sélection de puce et ledit signal d'instruction généré par ledit moyen de comparaison et pour activer ledit circuit de stockage de données lorsqu'un signal correspondant desdits signaux de sélection de puce et desdits signaux d'instruction sont reçus.

3. Dispositif selon la revendication 1 ou la revendication 2, dans lequel ledit moyen de génération d'adresse comprend :

un moyen de mémoire (28) pour stocker une pluralité de jeux de données définis pour les M lignes de données d'entrée/sortie respectives, chacun desdits jeux de données ayant, pour chacune desdites M lignes de données d'entrée/sortie, un numéro de colonne spécifiant une desdites colonnes et l'adresse de puce spécifiant une des puces de mémoire et pour fournir un des jeux de données ayant M nombres de colonnes et M adresses de puce définis pour lesdites M lignes de données d'entrée/sortie en réponse audit signal d'adresse externe ; et

un moyen de fourniture d'adresse (30) pour recevoir un desdits jeux de données dudit moyen de mémoire et pour fournir lesdites M adresses de puce auxdites M adresses de lignes dans des colonnes respectives spécifiées par lesdits M nombres de colonnes et pour fournir lesdits M nombres de colonnes audit moyen sélecteur comme ledit signal de sélection.

4. Dispositif selon la revendication 1, 2 ou 3, dans lequel ladite adresse de puce indique un emplacement d'une puce desdites puces de mémoire correspondante dans une direction dans laquelle lesdites puces de mémoire sont disposées dans les rangées.

5. Dispositif selon la revendication 1, 2, 3 ou 4, dans lequel ladite adresse de puce indique un ordre d'accès à une puce correspondante desdites puces de mémoire dans une direction dans laquelle lesdites puces de mémoire sont disposées dans les rangées.

6. Dispositif selon la revendication 1, 2, 3, 4 ou 5 dans lequel :

chacune desdites puces de mémoire a une zone de stockage (26) ayant une pluralité de blocs, une de ladite pluralité de blocs étant spécifiée par une adresse de bloc transférée via une desdites lignes de signal commun correspondante, et

ledit moyen de génération d'adresse comprend :

un moyen de mémoire (28) pour stocker une pluralité de jeux de données définis pour les M lignes de données d'entrée/sortie respectives, chacun desdits jeux de données ayant, pour chacune desdites M lignes de données d'entrée/sortie, un numéro de colonne spécifiant une desdites colonnes, l'adresse de puce spécifiant une puce desdites puces de mémoire et une adresse de bloc spécifiant un bloc desdits blocs et pour fournir un des jeux de données ayant M nombres de colonnes, M adresses de puce et M adresses de bloc définis pour lesdites M lignes de données d'entrée/sortie en réponse audit signal d'adresse externe ; et un moyen de fourniture d'adresse (30) pour recevoir un desdits jeux de données dudit moyen de mémoire et pour fournir lesdites M adresses de puce et M adresses de bloc aux M lignes d'adresse dans des colonnes respectives spécifiées par lesdits M nombres de colonnes.

7. Dispositif selon l'une quelconque des revendications précédentes comprenant :

des groupes de Y lignes de données (D0, D1 ; D2, D3 ; D4, D5) étant pourvus desdites N lignes de données pour les colonnes respectives où N et Y sont des entiers arbitraires et Y est plus petit que N, les données étant écrites ou extraites dudit circuit de stockage de données d'une des puces de mémoire via une desdites Y lignes de données, et lesdites cellules de mémoire étant spécifiées par le signal d'adresse dans la puce transférée via une desdites lignes de signal commun correspondante ; comprenant en outre un second moyen de registre (62) pour enregistrer des informations indiquant une desdites Y lignes de données ; et un moyen de sélection de ligne de données (64, 66) pour connecter ledit circuit de stockage de données à une desdites Y lignes de données enregistrée dans ledit second moyen de registre.

8. Dispositif selon l'une quelconque des revendications précédentes, où le nombre desdites colonnes est égal à M, et

où ledit moyen de génération d'adresse (20) comprend :

un moyen de mémoire (28) pour stocker une pluralité de jeux de données définis pour les M lignes de données d'entrée/sortie respectives, chacun desdits jeux de données ayant, pour chacune desdites lignes de données d'entrée/sortie, un nombre de données spécifiant une desdites Y lignes de données et l'adresse de puce spécifiant une des puces de mémoire et pour fournir un des jeux de données ayant M nombres de données et M adresses de puce définis pour lesdites M lignes de données d'entrée/sortie en réponse audit signal d'adresse externe ; et un moyen de fourniture d'adresse (30) pour recevoir un desdits jeux de données dudit moyen de mémoire et pour fournir lesdites M adresses de puce et ledit nombre de données aux lignes d'adresse dans les colonnes respectives et pour fournir lesdits M nombres de données audit moyen sélecteur comme ledit signal de sélection.

# FIG. I PRIOR ART

EP 0 446 002 B1

# FIG.2

13

# FIG.3

## FIG.4A

| B0 | | B1 | | B2 | |
|---|---|---|---|---|---|
| COLUMN NUMBER (No-0) | CHIP ID NUMBER (ID-0) | COLUMN NUMBER (No-1) | CHIP ID NUMBER (ID-1) | COLUMN NUMBER (No-2) | CHIP ID NUMBER (ID-3) |

## FIG.4B

| B0 | | B1 | | B2 | |
|---|---|---|---|---|---|
| 1 | 3 | 2 | 4 | 4 | 2 |

EP 0 446 002 B1

# FIG.5A

# FIG.5B

# FIG.5C

28a

30h

IN-CHIP ADDRESS, $\overline{RAS}$, $\overline{CAS}$, $\overline{WE}$

1ST COLUMN

2ND COLUMN

3RD COLUMN

4TH COLUMN

5TH COLUMN

EP 0 446 002 B1

## FIG.6A

## FIG.6B

# FIG.7

10(26)

DEFECTIVE
BLOCK

BLOCK

BLOCK

BLOCK

# FIG.8

| B0 | | | B1 | | | B2 | | |
|---|---|---|---|---|---|---|---|---|
| COLUMN NUMBER (No-0) | CHIP ID NUMBER (ID-0) | BLOCK ADDRESS (AD-0) | COLUMN NUMBER (No-1) | CHIP ID NUMBER (ID-1) | BLOCK ADDRESS (AD-1) | COLUMN NUMBER (No-2) | CHIP ID NUMBER (ID-2) | BLOCK ADDRESS (AD-2) |

EP 0 446 002 B1

FIG.9

→ 18,32

BO { No-0 / ID-0 / AD-0 }
BI { No-1 / ID-1 / AD-1 }
B2 { No-2 / ID-2 / AD-2 }

30a  30d  30D  30g

→ CHIP ID (No=0)
→ CHIP ID (No=1)
→ CHIP ID (No=2)
→ CHIP ID (No=3)
→ CHIP ID (No=4)

30i  30j

→ BLOCK AD (No=0)
→ BLOCK AD (No=1)
→ BLOCK AD (No=2)
→ BLOCK AD (No=3)
→ BLOCK AD (No=4)

30E

30F  30h

IN-BLOCK ADDRESS RAS,CAS,WE

→ 1ST COLUMN (No=0)
→ 2ND COLUMN (No=1)
→ 3RD COLUMN (No=2)
→ 4TH COLUMN (No=3)
→ 5TH COLUMN (No=4)

EP 0 446 002 B1

EP 0 446 002 B1

# FIG.10

18
DEFECTIVE BLOCK
NORMAL BLOCK
10

23

# FIG. 11

# FIG.12

EP 0 446 002 B1

## FIG.13A

| B0 | | B1 | | B2 | |
|---|---|---|---|---|---|
| DATA NUMBER (DNo-0) | CHIP ID NUMBER (ID-0) | DATA NUMBER (DNo-1) | CHIP ID NUMBER (ID-1) | DATA NUMBER (DNo-2) | CHIP ID NUMBER (ID-3) |

## FIG.13B

| B0 | | B1 | | B2 | |
|---|---|---|---|---|---|
| 0 | 1 | 2 | 1 | 4 | 1 |

EP 0 446 002 B1

# FIG.14

CHIP NUMBER

DEFECTIVE CHIP

INPUT/OUTPUT DATA LINE

ACCESSING ORDER

# FIG.15

CHIP ADDRESS
REGISTER 22

DATA SELECT
REGISTER 62

EP 0 446 002 B1

# FIG.16

1 ST COLUMN(No-0)
2 ND COLUMN(No-1)
3RD COLUMN(No-2)
4TH COLUMN(No-3)
5TH COLUMN(No-4)

—12
180
13

— CHIP ID = 1
— CHIP ID = 2
— CHIP ID = 3
— CHIP ID = 4
— CHIP ID = 5
— CHIP ID = 6

10
20

ID1  ID2  ID3  ID4  ID5

D0  D1  D2  D3  D4